# EUROPEAN PATENT APPLICATION

(11) **EP 4 716 426 A1**
(43) Date of publication of application: **25.03.2026**
(21) Application number: 24814631.8
(22) Date of filing: 01.06.2024
(51) Int. Cl.: H10H 20/852, H10H 20/857, H10H 20/832

(54) **LED PACKAGE STRUCTURE**

(30) Priority: 02.06.2023 CN 202310649515
(71) Applicant: Huaian Aucksun Optoelectronics Technology Co., Ltd, Huaian, Jiangsu 223000 (CN)
(72) Inventor: CHEN, Kai, Huaian, Jiangsu 223000 (CN); LU, Ling, Huaian, Jiangsu 223000 (CN); HUANG, Jing, Huaian, Jiangsu 223000 (CN)
(74) Representative: Metida
(86) International application number: PCT/CN2024/096911
(87) International publication number: WO 2024/245437

(57) **Abstract**

Disclosed in the present invention is an LED package structure, comprising a first bonding pad structure and a second bonding pad structure electrically connected to two electrodes of an LED chip respectively, the first bonding pad structure and the second bonding pad structure being mutually insulated, the first bonding pad structure and the second bonding pad structure being sized to respectively and electrically connected to the first polarity electrode and the second polarity electrode of the LED chip, and the sum of the bottom areas of the first bonding pad structure and the second bonding pad structure being 0.3-1 times of the bottom area of the LED chip package. By means of growing the larger-area bonding pad structures below the small-size chip electrodes, the solution increases the contact area between the chip and the substrate bonding pads, and increases the placement fault-tolerant rate, thereby achieving direct use of a CSP without introducing in a conductive plate, and improving the yield of surface mounting.

## Description

### TECHNICAL FIELD

The present invention relates to the field of semiconductor technologies, and in particular, to an LED packaging structure.

### BACKGROUND ART

Mini/MicroLED is an emerging display technology composed of millions of tiny LEDs, each capable of emitting light independently. This structure enables Mini/MicroLED to deliver higher contrast ratios and wider color gamut. In additional, Mini/MicroLED displays have higher brightness and faster refresh rates, allowing them to perform exceptionally well when displaying dynamic images. Compared with traditional LCD displays, Mini/MicroLED displays do not require a backlight, as each LED is capable of emitting light independently. This allows Mini/MicroLED displays to better control the brightness of each pixel, thereby providing higher contrast ratios and more realistic colors. Compared with OLED displays, Mini/MicroLED displays have higher brightness and longer service life. The reason for this is that OLED materials degrade over time, whereas LED materials do not degrade over time.

However, Mini/MicroLED currently faces some technical bottlenecks, one of which is the low efficiency and yield rate in packaging. The chips used in Mini/MicroLED are extremely small in size, and their electrode areas are correspondingly small. During the packaging process, it is difficult to achieve proper connection between the chip electrodes and the substrate pads by controlling the Mini/MicroLED chips with extremely high precision, making it hard to ensure that each LED is placed correctly.

### SUMMARY

The purpose of the present invention is to provide an LED packaging structure. By increasing areas of chip pads to improve a chip pad structure and an electrode structure directly connected to the pads, the accuracy of placing microchips pad on a substrate is enhanced, thereby improving the packaging efficiency and yield rate.

The present invention is realized through the following technical solutions.

An LED packaging structure is provided. The LED packaging structure comprises an LED chip, a fluorescent film covering an upper surface of the LED chip, a pad structure arranged on a lower surface of the LED chip, a first reflective layer covering side walls of the LED chip, and a second reflective layer covering side walls of the LED pad structure. The pad structure comprises a first pad electrically connected to a first electrode of the LED chip and a second pad connected to a second electrode of the LED chip. The first pad and the second pad are insulated from each other, and a sum of bottom areas of the pad structure is 0.3 to 1 times a bottom area of a packaging structure of the LED chip.

Further, the first electrode of the LED chip is composed of multiple metal layers, and/or the second electrode of the LED chip is composed of multiple metal layers. From an end proximate to the LED chip to an end proximate to the pad structure, the multiple metal layers sequentially comprise a Ti layer, a Cu layer, a Ni layer, and an Au layer, or sequentially comprise a Cr layer, a Cu layer, a Ni layer, and an Au layer.

Further, the first electrode has a thickness of 1 µm to 100 µm and/or the second electrode has a thickness of 1 µm to 100 µm. The Ti layer or the Cr layer has a thickness of 100 Å to 5000 Å. The Cu layer has a thickness of 1 µm to 100 µm. The Ni layer has a thickness of 1 µm to 10 µm. The Au layer has a thickness of 200 Å to 5000 Å.

Further, the first pad and the second pad each comprise an upper metal layer proximate to the LED chip and a lower metal layer away from the LED chip. The upper metal layer is a Cu metal layer, and the lower metal layer is an Au metal layer, a Sn metal layer, or a SnAg alloy layer.

Further, the upper metal layer has a thickness of 1 µm to 100 µm, and the lower metal layer has a thickness of 1 µm to 100 µm; and/or a Cr or Ti adhesive metal layer is further arranged between the upper metal layer and the LED chip (2), and the adhesive metal layer has a thickness of 100 Å to 5000 Å; and/or a Ni or Pt barrier layer is further arranged between the upper metal layer and the lower metal layer, and the barrier layer has a thickness of 1 µm to 10 µm; and/or the lower metal layer is a SnAg alloy layer, and has an Ag content of 0.5% to 3.5%.

Further, the first pad is provided with a first through-slot that is not connected to the first electrode, and/or the second pad is provided with a second through-slot that is not connected to the second electrode.

Further, patterns and/or sizes of the first through-slot and the second through-slot are different for distinguishing the first pad and the second pad. An area of the first through-slot accounts for 0% to 15% of the area of the first pad; and/or an area of the second through-slot accounts for 0% to 15% of the area of the second pad.

Further, a distance D2 between the first pad and the second pad is less than or equal to a distance D1 between the first electrode and the second electrode, and D2 is greater than or equal to 150 µm.

Further, an upper end of the first reflective layer is higher than the lower surface of the LED chip, and a lower end of the first reflective layer is flush with the lower surface of the LED chip. An upper end of the second reflective layer is flush with the lower surface of the LED chip, and a lower end of the second reflective layer is flush with a lower surface of the pad structure.

Further, a width of the fluorescent film (1) is greater than a width of the LED chip (2) and is less than a width of the first reflective layer (4), and a top surface of the first reflective layer is flush with a top surface of the fluorescent film (1); and/or the width of the fluorescent film (1) is greater than the width of the LED chip (2), the top surface of the first reflective layer (4) is flush with the upper surface of the LED chip (2), and the fluorescent film (1) covers the upper surface of the LED chip (2) and the top surface of the first reflective layer (4); and/or the width of the fluorescent film (1) is greater than the width of the LED chip (2), the fluorescent film (1) covers the upper surface of the LED chip (2) and partially wraps the side walls of the LED chip (2), and the top surface of the first reflective layer (4) is flush with bottoms of side surfaces of the fluorescent film (1).

Further, a width of the fluorescent film is greater than a width of the LED chip, the fluorescent film covers the upper surface of the LED chip and partially wraps the side walls of the LED chip, and a top surface of the first reflective layer is flush with bottoms of side surfaces of the fluorescent film.

Further, a bowl structure (5) is arranged between the first reflective layer (4) and the LED chip (2), and the bowl structure (5) is arranged on the surrounding side walls of the LED chip (2).

Compared with the prior art, the present invention has the following advantages.

A size of an existing chip electrode is too small, making it difficult to directly use for SMD mounting, so that packaging is usually performed with the help of a bracket. The present solution expands a contact area between a chip and a conductive substrate and increases a placement tolerance by growing a pad structure with a larger area under a small-sized chip electrode. Thus, the direct use of CSP may be realized without introducing a bracket, and the mounting yield rate is improved.

An area difference between the pad structure and the LED electrode is enlarged, which increases a stress between the pad structure and a first layer of high-reflectivity white gel. Therefore, it is necessary to control the area of the pad structure. Moreover, by making slots in the pad structure, the stress may be effectively relieved, and the risk of falling off is reduced. Moreover, the slots with different shapes may be designed to distinguish positive and negative poles of the LED.

A second layer of high-reflectivity white gel covers the pad structure, which plays a role in protecting the stability of the expanded pad structure.

### BRIEF DESCRIPTION OF DRAWINGS

FIG. 1 is a schematic diagram of an LED packaging structure in Embodiment 1;
FIG. 2 is a schematic diagram of an LED chip structure in Embodiment 1;
FIG. 3 is a schematic bottom view of FIG. 1;
FIG. 4 is a schematic diagram of an LED packaging structure in Embodiment 2;
FIG. 5 is a schematic diagram of an LED packaging structure in Embodiment 3;
FIG. 6 is a schematic diagram showing growth areas of a first pad and a second pad of an LED packaging structure in Embodiment 4; and
FIG. 7 is a schematic diagram showing growth areas of a first pad and a second pad of an LED packaging structure in Embodiment 5.

In the figures:
1. fluorescent film; 2. LED chip; 2a. upper surface; 2b. lower surface; 2c. side wall; 210. substrate; 211. N-type semiconductor layer; 212. multiple quantum well layer; 213. P-type semiconductor layer; 214. N electrode; 2141. first N electrode; 2142. second N electrode; 215. P electrode; 2151. first P electrode; 2152. second P electrode; 216. insulating layer; 217. conductive layer; 3. electrode; 4. first reflective layer; 5. bowl structure; 6.1. first pad; 6.11. first through-slot; 6.2. second pad; 6.21. second through-slot; 7. second reflective layer.

### DETAILED DESCRIPTION OF EMBODIMENTS

The technical solutions of the present invention will be clearly and completely described below with reference to the drawings. Obviously, the described embodiments are part of the embodiments of the present invention, rather than all the embodiments. Based on the embodiments of the present invention, all other embodiments obtained by those of ordinary skill in the art without making creative efforts shall fall within the protection scope of the present invention.

In the description of the present invention, it should be noted that an orientation or positional relationship indicated by the term such as "center", "upper", "lower", "left", "right", "vertical", "horizontal", "inner", "outer" is based on an orientation or positional relationship shown in the drawings, which is only for the convenience of describing the present invention and simplifying the description, rather than indicating or implying that the referred device or element must have a specific orientation, be constructed and operated in a specific orientation, and thus cannot be construed as a limitation to the present invention. In addition, the terms "first", "second" and "third" are only used for descriptive purposes, and shall not be construed as indicating or implying relative importance.

The present invention is realized through the following technical solutions.

### Embodiment 1

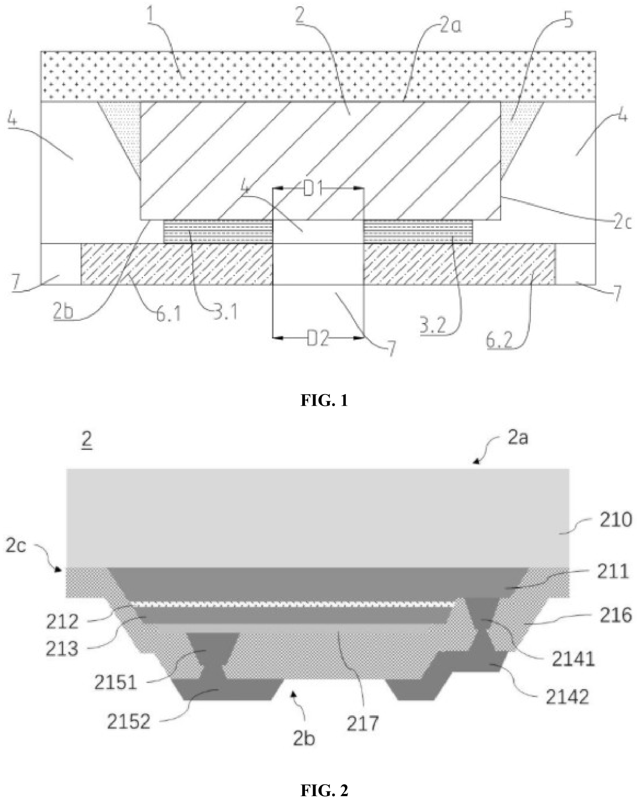

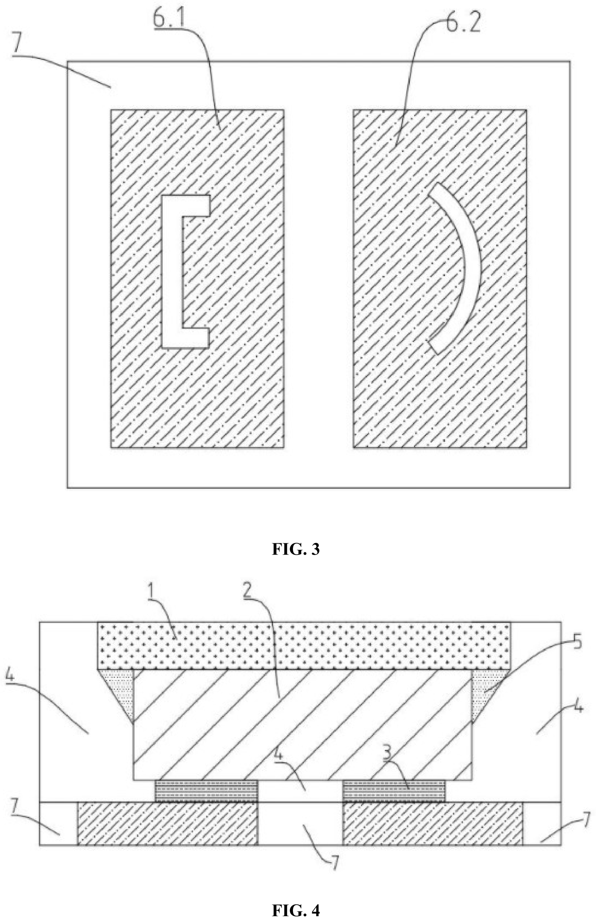

As shown in FIG. 1, FIG. 1 is a schematic diagram of an LED packaging structure. The LED packaging structure includes an LED chip 2, a fluorescent film 1, a pad structure 6, a first reflective layer 4, and a second reflective layer 7. As a light-emitting unit, the LED chip 2 has an upper surface 2a and a lower surface 2b opposite to each other, side walls 2c connecting the upper surface 2a and the lower surface 2b, and first electrode(s) 3.1 and second electrode(s) 3.2 that are located on the lower surface and separated from each other. The first electrode 3.1 and the second electrode 3.2 are opposite, that is, if the first electrode 3.1 is a P-type electrode, the second electrode 3.2 is an N-type electrode; if the first electrode 3.1 is an N-type electrode, the second electrode 3.2 is a P-type electrode. Moreover, the number of the first electrode(s) 3.1 and the number of the second electrode(s) 3.2 may each be one or more according to design requirements. The fluorescent film 1 is arranged on the upper surface (i.e., light exit surface) of the LED chip 2, and is used to convert a wavelength of at least part of light emitted from the LED chip 2 into other wavelengths. The first reflective layer 4 covers the side walls 2c of the LED chip, and exposes at least part of a bottom surface of the first electrode 3.1 and at least part of a bottom surface of the second electrode 3.2. The pad structure 6 includes a first pad 6.1 electrically connected to the first electrode 3.1 and a second pad 3.2 electrically connected to the second electrode 3.2. In a horizontal projection, the first pad 6.1 and the second pad 6.2 have the same shape and are respectively greater than an area of the first electrode 3.1 and an area of the second electrode 3.2, as shown in FIG. 3, which is a schematic bottom view of the LED packaging structure. The second reflective layer 7 covers side walls of the first pad 6.1 and the second pad 6.2, and exposes at least part of a bottom surface of the first pad 6.1 and at least part of a bottom surface of the second pad 6.2.

More specifically, FIG. 2 shows a schematic structural diagram of the above LED chip 2. The LED chip 2 is a flip-chip LED chip 2, including an N-type semiconductor layer 211, a multiple quantum well layer 212, a P-type layer 213, and N electrode(s) 214 electrically connected to the N-type semiconductor layer and P electrode(s) 215 electrically connected to the P-type semiconductor layer. The first electrode 3.1 and the second electrode 3.2 are each electrically connected to any one of the above N electrode 214 and P electrode 215. During the preparation of the N electrode(s) 214 and the P electrode(s) 215, they may be formed through multiple processes, thereby forming multiple N electrodes and multiple P electrodes. In this embodiment, the N electrode(s) 214 include a first N electrode 2141 and a second N electrode 2142 that are electrically connected, and the P electrode(s) include a first P electrode 2151 and a second P electrode 2152 that are electrically connected. An insulating layer 216 for insulating the N electrode 214 and the P electrode 215 from each other, and a conductive layer 217 arranged between the P electrode 215 and the P-type semiconductor layer are included. Usually, the first N electrode 2141 and the first P electrode 2151 are dot-shaped electrodes or finger-shaped electrodes arranged in a scattered manner, and the second N electrode 2142 and the second P electrode 2152 are planar electrodes. The first electrode 3.1 and the second electrode 3.2, as connecting electrodes for connecting the LED chip and the pad structure, may be completed in a chip factory or completed separately before packaging. The first electrode 3.1 and the second electrode 3.2 are usually columnar structures, and their thicknesses are greater than those of the N electrode 214 and the P electrode 215. The first electrode 3.1 and the second electrode 3.2 have a thickness of 1 µm to 100 µm, preferably 30 µm to 70 µm, and have a material of a metal material or a metal alloy, such as Ti, Ni, Cu, Au, Pt or a combination thereof, but it is not limited thereto. In addition to insulating the P electrode and the N electrode from each other, the insulating layer also plays a role in protecting the structure of the LED chip. In some implementations, the insulating layer also has reflectivity. For example, the insulating layer is set as a DBR structure with grooves of different insulating materials, or a metal reflective layer is sandwiched in insulating materials. The conductive layer 217 plays a role in current spreading, and is laid on a surface of the P-type semiconductor layer 213 as widely as possible and has light transmittance. The conductive layer 217 is an indium tin oxide (ITO) layer or an indium zinc oxide (IZO) layer.

In this embodiment, the first electrode 3.1 and the second electrode 3.2, as structures connecting the LED chip to the first pad 6.1 and the second pad 6.2, are each composed of multiple metal layers. From an end proximate to the LED chip to an end proximate to the pad structure, the multiple metal layers sequentially include a Ti layer, a Cu layer, a Ni layer, and an Au layer, or sequentially include a Cr layer, a Cu layer, a Ni layer, and an Au layer. The Ti layer or the Cr layer serves as an adhesion layer with a thickness of 100 Å - 5000 Å. The Cu layer has excellent electrical and thermal conductivity, and as a main component of the first electrode 3.1 and the second electrode 3.2, the Cu layer has a thickness of 1 µm to 100 µm, preferably 30 µm to 60 µm. The Au layer serves as an outermost metal with a thickness of 200 Å to 5000 Å, preferably 650 Å to 950 Å. The Ni layer is arranged between the Cu layer and the Au layer, with a thickness of 1 µm to 10 µm, preferably 2 µm to 4 µm.

In this embodiment, the first pad 6.1 and the second pad 6.2 are arranged to completely overlap the first electrode 3.1 and the second electrode 3.2, respectively, and each extend toward an edge of the first reflective layer 4 but do not extend to the edge of the first reflective layer 4. The first pad 6.1 and the second pad 6.2 are rectangular, square or circular in shape from a top view, and a sum of their sizes is 0.3 to 1 times the packaging size Dw of the LED chip 2, preferably 0.6 to 0.95 times. A larger pad structure is used for heat dissipation on the one hand and for facilitating connection with external electrodes on the other hand. In other unshown implementations, the first pad 6.1 and the second pad 6.2 may each extend to the edge of the first reflective layer 4 or beyond the edge of the first reflective layer 4.

Specifically, the first pad 6.1 and the second pad 6.2 each include an upper metal layer proximate to the LED chip 2 and a lower metal layer away from the LED chip. The upper metal layer is a Cu metal layer, and the lower metal layer is an Au metal layer, a Sn paste layer or a SnAg alloy layer. The upper metal layer has a thickness of 1 µm to 100 µm, preferably 20 µm to 50 µm, and the lower metal layer has a thickness of 1 µm to 100 µm, preferably 20 µm to 50 µm. When the lower metal layer is the SnAg alloy layer, the lower metal layer has an Ag content of 0.5% to 3.5%.

In an embodiment, a Cr or Ti adhesive metal layer is further arranged between the upper metal layer and the LED chip 2, and the adhesive metal layer has a thickness of 100 Å to 5000 Å. In another embodiment, a Ni or Pt barrier layer is further arranged between the upper metal layer and the lower metal layer, and the barrier layer has a thickness of 1 µm to 10 µm, preferably 1.5 µm to 4 µm.

The fluorescent film layer 1 may be formed by first mixing a dopant with a colloid to form a precursor, and then performing a film-forming process. The dopant is a phosphor, including one or more of KSF phosphor, nitride phosphor, silicate phosphor, chlorate phosphor, YAG phosphor, and sulfide-containing phosphor. In this embodiment, since the required LED package emits white light, while light emitted from the LED chip 2 is blue light, yellow phosphor is needed to convert blue light into white light.

In this embodiment, the reflectivity of the first reflective layer 4 and/or the second reflective layer 7 is greater than 90%, and the material is a transparent silica gel doped with reflective particles, i.e., high-reflectivity white gel. The reflective particles may be insulating particles, such as TiO₂, SiO₂, SiN, etc., or metal particles, such as Al particles, Ag particles, Cu particles, etc.

Further, a distance D2 between the first pad 6.1 and the second pad structure 6.2 is ≤ a distance D1 between the first electrode and the second electrode, and D2 ≥ 150 µm. If D2 is less than 150 µm, the too narrow D2 causes the diffusion and migration of Sn paste when the first pad 6.1 and the second pad 6.2 are used in actual mounting, which is likely to lead to the connection between the first pad 6.1 and the second pad 6.2 and thus a short circuit. The first pad 6.1 and the second pad 6.2 each have a shortest distance D3 from their side wall to a side wall of the second reflective layer 7, where D3 > 0, preferably, D3 is greater than 100 µm.

An upper end of the first reflective layer 4 is flush with the upper surface 2a of the LED chip 2, and a lower end of the first reflective layer 4 is flush with a lower surface of the first electrode 3.1 and/or a lower surface of the second electrode 3.2. An upper end of the second reflective layer 7 is flush with the lower surface of the first electrode 3.1 and/or the lower surface of the second electrode 3.2, and a lower end of the second reflective layer 7 is flush with a lower surface of the first pad 6.1 and/or a lower surface of the second pad 6.2. A width of the fluorescent film 1 is greater than a width of the LED chip 2, covering the upper surface 2a of the LED chip and a top surface of the first reflective layer 4.

Further, in the LED packaging structure provided in the present invention, a bowl structure 5 is arranged between the first reflective layer 4 and the LED chip 2. The bowl structure 5 is arranged on the surrounding side walls of the LED chip 2. The bowl structure is a transparent reflective cavity, preferably, is made of a transparent silica gel.

### Embodiment 2

As shown in FIG. 4, differences between this embodiment and Embodiment 1 are as follows. The fluorescent film 1 in this embodiment is first arranged on the upper surface of the LED chip. Due to a dicing street, a width of the fluorescent film 1 is greater than the width of the LED chip 2. Moreover, since the chip packaging structure in this embodiment includes the bowl structure, the width of the fluorescent film 1 is approximately 50 to 200 µm greater than the width of the LED chip 2. Then, the bowl structure 5 and the first reflective layer 4 are arranged, and the bowl structure is arranged around an upper end of side surfaces of the LED chip 2. The first reflective layer 4 covers the side walls of the LED chip 2 and the fluorescent film 1, and the top surface of the first reflective layer 4 is flush with a top surface of the fluorescent film 1. The rest of the structure is the same, and will not be repeated here.

Compared with the structure in Embodiment 1, the structure of this embodiment also emits light from a single side, but has a smaller light-emitting angle (110° to 120°), and the color temperature distribution of light in space is more concentrated.

### Embodiment 3

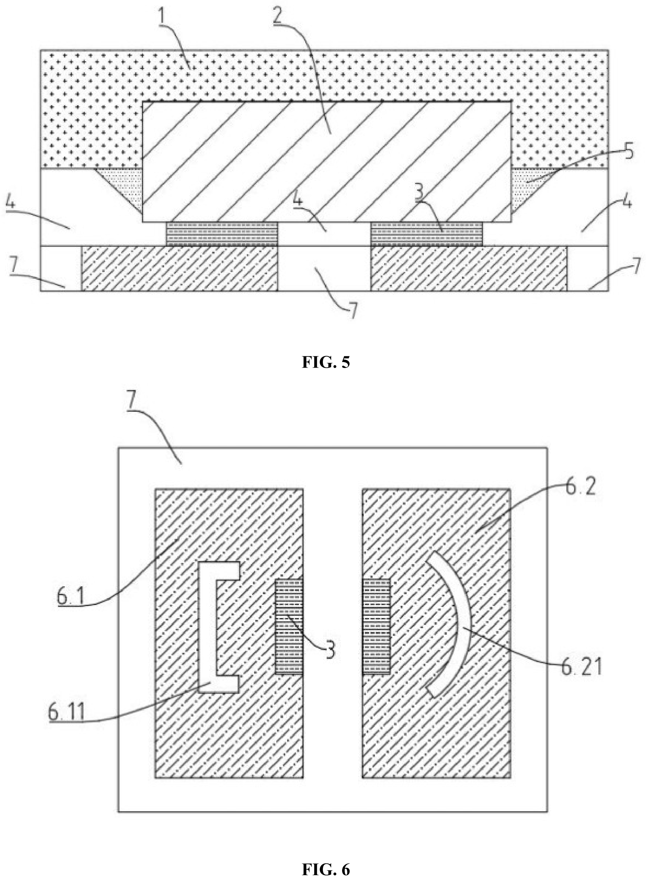

As shown in FIG. 5, differences between this embodiment and Embodiment 1 are as follows. The width of the fluorescent film 1 in this embodiment is greater than the width of the LED chip 2, and the fluorescent film 1 covers the upper surface of the LED chip and partially wraps the side walls 2c of the LED chip. The top surface of the first reflective layer 4 is coplanar with a bottom surface of the fluorescent film, and side walls of the first reflective layer 4 are coplanar with side walls of the fluorescent film. The rest of the structure is the same, and will not be repeated here.

Compared with the structure in Embodiment 1, the structure in this embodiment is a five-sided light-emitting structure with a larger light-emitting angle, which may reach 150°. Side light of the LED is utilized, so that the light-emitting brightness is higher.

### Embodiment 4

As shown in FIG. 6, differences between this embodiment and Embodiment 1 are as follows. The first pad 6.1 is provided with first through-slot(s) 6.11, and the second pad 6.2 is provided with second through-slot(s) 6.21. The function of the first through-slot 6.11 and the second through-slot 6.21 is as follows. An area difference between the first pad 6.1 and the first electrode 3.1 and an area difference between the second pad 6.2 and the second electrode 3.2 increase a stress between the first reflective layer 4 and the high-reflectivity white gel. By designing through-slots on the first pad 6.1 and the second pad 6.2, the stress may be effectively relieved, thereby reducing the risk of metal layer falling off. However, the first through-slot 6.11 is not connected to the first electrode 3.1, and the second through-slot 6.21 is not connected to the second electrode 3.2 to avoid electric leakage. Therefore, as shown in this embodiment, the first through-slot 6.11 needs to be arranged on an edge side away from the first electrode 3.1, and the second through-slot 6.21 needs to be arranged on an edge side away from the second electrode 3.2; or a depth of the first through-slot 6.1 is less than a thicknesses of the first pad, and a depth of the second through-slot is less than a thicknesses of the second pad. The first through-slot 6.11 and the second through-slot 6.21 may be square, circular, arc-shaped, triangular, polygonal or a combination of one or more of the above shapes, and the square shape is selected in this embodiment. There may be multiple first through-slots 6.11 distributed in the first pad 6.1 and multiple second through-slots 6.21 distributed in the second pad 6.2, and the multiple first through-slots 6.11 account for 0% to 15% (preferably 2% to 10%) of an area of the first pad 6.1 and the multiple second through-slots 6.21 account for 0% to 15% (preferably 2% to 10%) of an area of the second pad 6.2.

In this embodiment, the first through-slot 6.11 needs to be arranged on the edge side away from the first electrode 3.1, and the second through-slot 6.21 needs to be arranged on the edge side away from the second electrode 3.2. Moreover, patterns of the first through-slot 6.11 and the second through-slot 6.21 are different. The first through-slot 6.11 is a U-shaped through-slot composed of multiple square structures, and the second through-slot 6.21 is an arc-shaped through-slot, for distinguishing the polarities of the first pad 6.1 and the second pad 6.2. Similarly, due to the different shapes of the first through-slot 6.11 and the second through-slot 6.21, it is difficult for their areas to be the same, but in a case where the areas of the first pad 6.1 and the second pad 6.2 are the same, an area difference between the first through-slot 6.11 and the second through-slot 6.21 is ≤ 10%.

### Embodiment 5

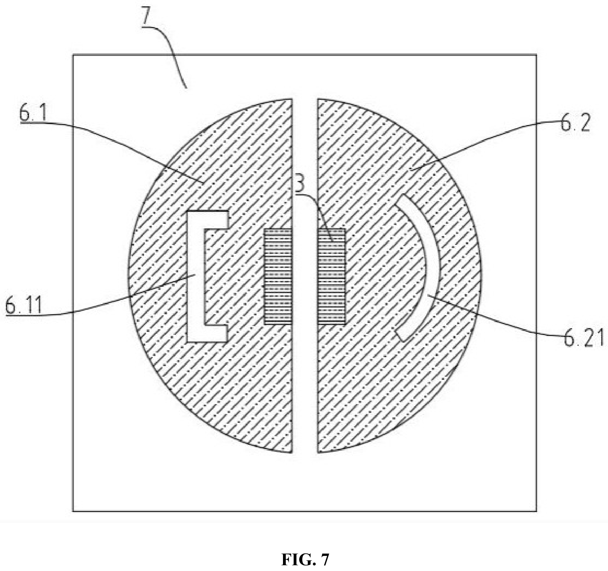

As shown in FIG. 7, differences between this embodiment and Embodiment 4 are as follows. In this embodiment, the first pad 6.1 and the second pad 6.2 are two semicircular disks joined together, and the two electrodes 3 are respectively located on sides each proximate to a straight edge of the semicircular disk. The rest of the structure is the same, and will not be repeated here.

The above implementations are only intended to illustrate the technical concept and characteristics of the present invention. Their purpose is to enable those familiar with this technology to understand the contents of the present invention and implement the present invention accordingly, and they cannot be used to limit the protection scope of the present invention. All equivalent transformations or modifications made according to the essence of the present invention shall be included in the protection scope of the present invention.

## Claims

1. An LED packaging structure, **characterized by** comprising an LED chip (2), a fluorescent film (1) covering an upper surface of the LED chip (2), a pad structure (6) arranged on a lower surface of the LED chip (2), a first reflective layer (4) covering side walls of the LED chip (2), and a second reflective layer (7) covering side walls of the LED pad structure, wherein the pad structure comprises a first pad (6.1) electrically connected to a first electrode (3.1) of the LED chip (2) and a second pad (6.2) connected to a second electrode (3.2) of the LED chip, the first pad (6.1) and the second pad (6.2) are insulated from each other, and a sum of bottom areas of the pad structure is 0.3 to 1 times a bottom area of a packaging structure of the LED chip (2); and an area of the first pad 6.1 is greater than an area of the first electrode 3.1, and an area of the second pad 6.2 is greater than an area of the second electrode 3.2.

2. The LED packaging structure according to claim 1, wherein the first electrode (3.1) of the LED chip (2) is composed of multiple metal layers, and/or the second electrode (3.2) of the LED chip (2) is composed of multiple metal layers; and from an end proximate to the LED chip (2) to an end proximate to the pad structure (6), the multiple metal layers sequentially comprise a Ti layer, a Cu layer, a Ni layer, and an Au layer, or sequentially comprise a Cr layer, a Cu layer, a Ni layer, and an Au layer.

3. The LED packaging structure according to claim 2, wherein the first electrode (3.1) has a thickness of 1 µm to 100 µm and/or the second electrode (3.2) has a thickness of 1 µm to 100 µm, wherein the Ti layer or the Cr layer has a thickness of 100 Å to 5000 Å; the Cu layer has a thickness of 1 µm to 100 µm; the Ni layer has a thickness of 1 µm to 10 µm; and the Au layer has a thickness of 200 Å to 5000 Å.

4. The LED packaging structure according to claim 1, wherein the first pad (6.1) and the second pad (6.2) each comprise an upper metal layer proximate to the LED chip (2) and a lower metal layer away from the LED chip (2), wherein the upper metal layer is a Cu metal layer, and the lower metal layer is an Au metal layer, a Sn metal layer, or a SnAg alloy layer.

5. The LED packaging structure according to claim 4, wherein the upper metal layer has a thickness of 1 µm to 100 µm, and the lower metal layer has a thickness of 1 µm to 100 µm; and/or
a Cr or Ti adhesive metal layer is further arranged between the upper metal layer and the LED chip (2), and the adhesive metal layer has a thickness of 100 Å to 5000 Å; and/or
a Ni or Pt barrier layer is further arranged between the upper metal layer and the lower metal layer, and the barrier layer has a thickness of 1 µm to 10 µm; and/or
the lower metal layer is a SnAg alloy layer, and has an Ag content of 0.5% to 3.5%.

6. The LED packaging structure according to claim 1, wherein the first pad (6.1) is provided with a first through-slot (6.11) that is not connected to the first electrode (3.1), and/or the second pad (6.2) is provided with a second through-slot (6.21) that is not connected to the second electrode (3.2).

7. The LED packaging structure according to claim 6, wherein patterns and/or sizes of the first through-slot (6.11) and the second through-slot (6.21) are different; an area of the first through-slot (6.11) accounts for 0% to 15% of an area of the first pad (6.1); and/or an area of the second through-slot (6.21) accounts for 0% to 15% of an area of the second pad (6.2).

8. The LED packaging structure according to claim 1, wherein a distance D2 between the first pad (6.1) and the second pad (6.2) is less than or equal to a distance D1 between the first electrode (3.1) and the second electrode (3.2), and D2 is greater than or equal to 150 µm.

9. The LED packaging structure according to claim 1, wherein an upper end of the first reflective layer (4) is higher than a lower surface of the LED chip (2), and a lower end of the first reflective layer (4) is flush with the lower surface of the LED chip (2); an upper end of the second reflective layer (7) is flush with the lower surface of the LED chip (2), and a lower end of the second reflective layer (7) is flush with a lower surface of the pad structure (6).

10. The LED packaging structure according to claim 9, wherein a width of the fluorescent film (1) is greater than a width of the LED chip (2) and is less than a width of the first reflective layer (4), and a top surface of the first reflective layer is flush with a top surface of the fluorescent film (1); and/or
the width of the fluorescent film (1) is greater than the width of the LED chip (2), the top surface of the first reflective layer (4) is flush with the upper surface of the LED chip (2), and the fluorescent film (1) covers the upper surface of the LED chip (2) and the top surface of the first reflective layer (4); and/or
the width of the fluorescent film (1) is greater than the width of the LED chip (2), the fluorescent film (1) covers the upper surface of the LED chip (2) and partially wraps the side walls of the LED chip (2), and the top surface of the first reflective layer (4) is flush with bottoms of side surfaces of the fluorescent film (1).

11. The LED packaging structure according to claim 9, wherein a width of the fluorescent film (1) is greater than a width of the LED chip (2), the fluorescent film (1) covers the upper surface of the LED chip (2) and partially wraps the side walls of the LED chip (2), and a top surface of the first reflective layer (4) is flush with bottoms of side surfaces of the fluorescent film (1).

12. The LED packaging structure according to claim 1, wherein a bowl structure (5) is arranged between the first reflective layer (4) and the LED chip (2), and the bowl structure (5) is arranged on the surrounding side walls of the LED chip (2).
